Europäisches Patentamt

European Patent Office

Office européen des brevets

(11) Numéro de publication: **0 233 096**
**A1**

# (12) DEMANDE DE BREVET EUROPEEN

(21) Numéro de dépôt: 87400038.3

(22) Date de dépôt: 09.01.87

(51) Int. Cl.⁴: **G 11 B 20/12,** H 03 M 7/30, G 06 F 5/06 // G06F3/06, G11B20/10

(30) Priorité: 13.01.86 FR 8600369

(43) Date de publication de la demande: 19.08.87 **Bulletin 87/34**

(84) Etats contractants désignés: **DE GB NL**

(71) Demandeur: **THOMSON-CGR, 13, square Max-Hymans, F-75015 Paris (FR)**

(72) Inventeur: **Lienard, Jean, THOMSON-CSF SCPI 19, avenue de Messine, F-75008 Paris (FR)**

(74) Mandataire: **Grynwald, Albert et al, THOMSON-CSF SCPI 19, avenue de Messine, F-75008 Paris (FR)**

(54) **Procédé de formattage et de déformattage de données résultant du codage d'informations numériques à l'aide d'un code à longueur variable, et dispositif de mise en oeuvre.**

(57) Le formatteur-déformatteur de l'invention comprend en particulier un formatteur formé d'un cadreur (8) relié à un registre d'entrée (9) dont la sortie est reliée, via un multiplexeur (10) à l'entrée de résidu (R) du cadreur, ainsi qu'à un premier registre intermédiaire (13) via un autre multiplexeur (12) et à un autre multiplexeur (19). Ce dernier est relié à un second registre intermédiaire (20) et à un multiplexeur de sortie (23), dont la sortie est reliée à un registre de sortie (25) faisant tampon pour la mémoire de masse.

Application: Imagerie Médicale.

EP 0 233 096 A1

ACTORUM AG

PROCEDE DE FORMATTAGE ET DE DEFORMATTAGE DE
DONNEES RESULTANT DU CODAGE D'INFORMATIONS NUMERIQUES
A L'AIDE D'UN CODE A LONGUEUR VARIABLE,
ET DISPOSITIF DE MISE EN OEUVRE

La présente invention se rapporte à un procédé de formattage et de déformattage de données résultant du codage d'informations numériques à l'aide d'un code à longueur variable, et à un dispositif de mise en oeuvre.

Pour enregistrer rapidement et avec le minimum d'encombrement un très grand nombre de données numériques telles que les valeurs successives des pixels d'une image numérisée, on comprime généralement ces données en utilisant un code à longueur variable, les valeurs codées successives étant concaténées et envoyées à une mémoire de masse telle qu'une unité à disques souples. Lorsque la vitesse d'acquisition des images est élevée (15 images par seconde ou plus), comme c'est le cas en imagerie médicale, les dispositifs connus de formattage assurant la concaténation ne sont pas suffisamment rapides, ce qui oblige soit à réduire la cadence d'acquisition des images, d'où perte d'informations, soit à utiliser alternativement plusieurs dispositifs de formattage et mémorisation, ce qui augmente considérablement le prix de revient du système.

La présente invention a pour objet un procédé de formattage-déformattage de données résultant du codage d'informations numériques à l'aide d'un code à longueur variable, procédé qui permette une grande vitesse d'acquisition de ces informations numériques, et la présente invention a également pour objet un dispositif de mise en oeuvre de ce procédé, dispositif qui soit simple et peu onéreux.

Le procédé de l'invention, qui vise au formattage, à concaténer des mots codés de longueur variable et à découper en entités de même longueur la chaîne ainsi obtenue, et à envoyer consécutivement ces entités à un dispositif de mémoire de masse, la longueur de ces entités étant égale au nombre d'éléments binaires pouvant être envoyés simultanément à ce dispositif de mémoire, et

2

au déformattage à effectuer les opérations inverses en vue de restituer lesdits mots codés, consiste, selon l'invention, au formattage, à mémoriser provisoirement et consécutivement les mots codés dans un registre d'entrée, en les cadrant, à la suite d'un éventuel résidu vers l'une des extrémités de ce registre, à les diviser, à partir de ladite extrémité, en tranches adjacentes de même longueur, la tranche comprenant l'autre extrémité pouvant être incomplète, et constituant ledit résidu, ces tranches comportant quatre éléments binaires, puis à transférer du registre du niveau de départ vers un registre de niveau de sortie, de capacité égale à la longueur desdites entités, en passant, le cas échéant, par des registres de niveaux intermédiaires, toutes les tranches complètes du niveau de départ, en décalant, le cas échéant, vers ladite extrémité du registre de niveau de départ la tranche incomplète restante, les registres de niveaux intermédiaires ayant chacun une capacité égale à un multiple entier de la longueur d'une tranche, cette capacité allant en croissant du niveau de départ au niveau d'arrivée, les tranches complètes étant transférées après celles des niveaux intermédiaires, dans l'ordre, en priorité vers le niveau d'arrivée jusqu'à achèvement de son remplissage, les tranches qui ne peuvent, le cas échéant, être transférées vers ce niveau d'arrivée du fait de son plein remplissage, étant transférées vers les registres de niveaux intermédiaires de manière à remplir soit, en priorité, ceux contenant déjà des tranches n'ayant pu précédemment être transférées vers le niveau d'arrivée, puis ceux dont la capacité est la plus proche de celle nécessaire pour loger les tranches restantes, en utilisant le minimum de niveaux, soit, si tous les niveaux intermédiaires sont vides, de manière à remplir un ou plusieurs de ces niveaux intermédiaires en en utilisant le minimum, le contenu de ces niveaux intermédiaires étant ensuite, en priorité, transféré vers le niveau d'arrivée, en respectant l'ordre d'ancienneté, le contenu du niveau d'arrivée étant transféré vers le dispositif de mémoire de masse dès qu'il est plein, et au déformattage à mémoriser provisoirement et consécutivement les tranches successives des codes concaténés en provenance de la mémoire de masse dans un registre de niveau supérieur de capacité au moins égale au plus long code utilisé, à pré-cadrer vers l'une des extrémités de ce registre le code le plus proche de cette extrémité du registre de façon que l'extrémité du code la plus proche de cette extrémité du registre arrive à l'extrémité d'une des zones d'extrémité de longueur déterminée du registre par décalage d'un nombre entier de fois la longueur de la zone, à transférer au moins partiellement dans un ou plusieurs registres intermédiaires le code ainsi pré-cadré en le cadrant sur une extrémité de ces registres, et à transférer dans un registre de sortie le code ainsi cadré. Selon un aspect du procédé de l'invention, on cadre d'abord le préfixe du code, puis son suffixe.

Le dispositif formatteur de l'invention comporte un dispositif cadreur relié à l'entrée d'un registre d'entrée dont la sortie est reliée d'une part à une entrée du dispositif cadreur via un premier multiplexeur, d'autre part à un premier registre intermédiaire via un second multiplexeur, et d'autre part à un troisième multiplexeur, la sortie du premier registre intermédiaire étant également reliée à ce troisième multiplexeur, la sortie du troisième multiplexeur étant reliée à un second registre intermédiaire et à un quatrième multiplexeur auquel est également reliée à la sortie du second registre intermédiaire, la sortie du quatrième multiplexeur étant reliée à un registre de sortie.

Le dispositif déformatteur de l'invention comporte un pré-cadreur suivi d'un cadreur, le pré-cadreur comportant au moins un registre d'entrée suivi d'un multiplexeur et d'un registre de pré-cadrage, le cadreur comportant au moins un étage de circuits logiques de décalage et un multiplexeur. Selon un aspect avantageux de l'invention, le cadreur comporte un cadreur de préfixe suivi d'un cadreur de suffixe comprenant chacun un étage de circuits logiques de décalage et un multiplexeur.

La présente invention sera mieux comprise à la lecture de la description détaillée d'un mode de réalisation pris comme exemple non limitatif et illustré par le dessin annexé, sur lequel :

4

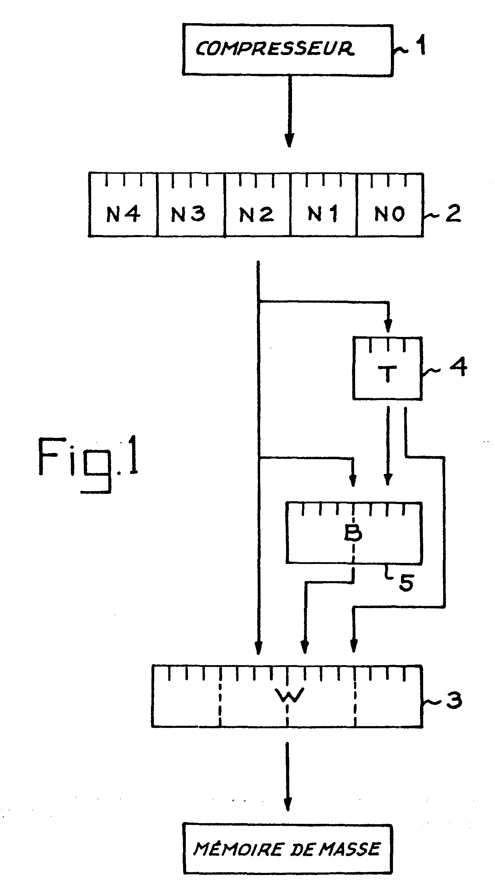

- la figure 1 est un diagramme explicatif du fonctionnement d'un formatteur conforme à l'invention ;

- la figure 2 est un bloc-diagramme d'un mode de réalisation d'un formatteur conforme à l'invention ;

- la figure 3 est un bloc-diagramme d'un circuit de cadrage par mixage utilisable dans le mode de réalisation de la figure 2 ;

- la figure 4 est un diagramme explicatif du fonctionnement d'un déformatteur conforme à l'invention ;

- la figure 5 est un bloc-diagramme d'un mode de réalisation de pré-cadreur d'un déformatteur conforme à l'invention, et

- la figure 6 est un bloc-diagramme d'un mode de réalisation de cadreur d'un déformatteur conforme à l'invention.

Le dispositif formatteur-déformatteur décrit ci-dessous est utilisé dans un équipement d'enregistrement en temps réel sur disques magnétiques d'images numérisées, telles que des images d'angiographie, après compression par code à longueur variable, les images ainsi enregistrées étant subséquemment restituées selon un processus inverse de traitement, mais il est bien entendu que l'invention n'est pas limitée à une telle application, et qu'elle peut être mise en oeuvre pour formatter diverses sortes de données numérisées et compressées selon un code à longueur variable, et, après enregistrement et/ou transmission, pour déformatter, décomprimer et restituer les données d'origine.

Les informations numériques provenant de la numérisation d'images sont comprimées dans un compresseur 1, qui utilise un code à longueur variable tel qu'un code de Huffman. Le rôle du formatteur est de concaténer ces codes, puis de découper la chaîne d'éléments binaires ainsi obtenue en tranches de longueur constante, la longueur de ces tranches étant telle qu'elles puissent être directement prises en compte et inscrites sur le disque magnétique par les circuits d'enregistrement de celui-ci. Cette longueur est généralement de seize éléments binaires pour des disques courants. Bien entendu, le traitement des images et leur enregistrement doivent se faire à une vitesse au moins égale à la vitesse d'acquisition de ces images.

5

Les codes, de longueur m variable, successivement issus du compresseur 1 sont envoyés à un -registre d'entrée 2 en étant cadrés, par exemple sur l'extrémité de droite (par rapport au dessin) de ce registre. Le registre 2 est divisé en "tranches" adjacentes égales. Dans un exemple de réalisation préféré, pour lequel la longueur maximale des codes à la sortie du compresseur est de seize éléments binaires et la longueur des mots envoyés au disque est de seize éléments binaires, le registre 2 a une capacité de vingt éléments binaires et est divisé en cinq tranches de quatre éléments binaires chacune, respectivement référencées N0 à N4.

Le dispositif formatteur comporte un registre de sortie 3 dont la capacité est, dans le cas présent, de seize éléments binaires, car ce registre charge une mémoire de masse, qui est ici une unité à disques souples dont l'entrée est à seize éléments binaires. Le formatteur comporte en outre un premier registre intermédiaire 4 dont la capacité est égale à celle d'une tranche du registre 2, et un second registre intermédiaire 5 dont la capacité est égale à celle de deux tranches du registre 2. Dans le cas présent, les capacités des registres 4 et 5 sont de quatre et huit éléments binaires respectivement. Le registre 2 peut charger, suivant son contenu, l'un ou plusieurs des registres 3 à 5, le registre 4 peut charger le registre 3 ou le registre 5, et le registre 5 peut charger le registre 3. On va expliquer ci-dessous comment s'effectuent ces différents chargements, qui se font toujours par multiples entiers de la longueur d'une tranche du registre 2.

Lorsqu'un premier mot de code est envoyé par le compresseur 1 au registre 2, ce mot est cadré sur l'extrémité de droite de ce registre, et plus précisément sur l'extrémité de droite de la tranche N0 du registre 2. Selon la longueur de ce mot, différentes possibilités de chargement des autres registres du formatteur peuvent avoir lieu :

- si la longueur de ce mot est inférieure ou égale à trois éléments binaires, il est chargé dans les trois cellules de droite de N0 et y reste. Le second mot provenant du compresseur sera chargé immé-

6

diatement à gauche de ce résidu, et l'information obtenue à partir de ces deux mots sera traitée comme expliqué ci-dessous à propos d'un premier mot d'une longueur d'au moins quatre éléments binaires,

- si la longueur de ce mot va de quatre à sept éléments binaires, les quatre éléments binaires de droite sont transférés dans le registre 4, et le résidu éventuel est ensuite transféré dans N0 et cadré à droite,

- si la longueur de ce mot va de huit à onze éléments binaires, les huit premiers en partant de la droite sont transférés dans le registre 5, et le résidu éventuel est ensuite transféré dans N0 et cadré à droite ;

- si la longueur de ce mot va de douze à quinze éléments binaires, les huit premiers à droite sont transférés dans le registre 5, les quatre suivants dans le registre 4, et le résidu éventuel est ensuite transféré dans N0 et cadré à droite ;

- et enfin, si la longueur de ce mot est de seize éléments binaires, ils sont directement transférés dans le registre 3, et le contenu du registre 3 est transféré vers la mémoire de masse.

Lorsque le compresseur 1 envoie au registre 2 le second mot de code, puis les mots de code suivants, qui sont, comme précisé ci-dessus, chargés immédiatement à gauche du résidu éventuel, ou cadrés à droite dans ce registre 2 s'il n'y a pas de résidu, les processus de transferts décrits ci-dessus restent valables, l'éventuelle occupation des registres 4 et 5 entraînant les transferts entre registres explicités dans le tableau N° 1 ci-dessous.

Dans ce tableau, la variable q est égale à la partie entière du rapport $l/n$, dans lequel $\underline{l}$ est la longueur de l'information contenue dans le registre 2 (avec $l = m + r$, m étant la longueur du mot de code envoyé par le compresseur 1 et r la longueur du résidu éventuel), et $\underline{n}$ est la longueur d'une tranche du registre 2, et dans le cas présent $n = 4$ et $\underline{r}$ peut donc aller de 0 à 3. Les contenus des registres 3, 4 et 5, lorsqu'ils sont pleins, sont respectivement notés W, T, B. Les variables f (W), f(T) et f(B) sont des "fanions" indiquant, s'ils sont égaux à 1, l'occupation des registres 3 , 4 et 5 respectivement, et s'ils sont égaux à 0, leur vacuité. Dans les deuxième et troisième colonnes les valeurs des fanions sont celles avant transfert, et dans la colonne de droite, ce sont celles après transfert. Dans la colonne "transferts", un transfert du niveau (tranche ou registre) (Y) au niveau (Z) est symbolisé par (Z) = (Y). Lorsqu'il y a transfert depuis plusieurs niveaux, ils sont notés, de gauche à droite dans l'ordre d'ancienneté croissant de leurs contenus respectifs (l'"ancienneté" dans le registre 2 allant en croissant de N4 vers N0 puisque les mots de code successifs sont chargés dans le registre 2 à gauche du résidu éventuel du mot précédent, ce résidu étant la partie gauche dudit mot précédent). Dans le tableau ci-dessous, les résidus éventuels ne sont pas mentionnés, puisqu'ils ne sont pas transférés.

Ainsi, le contenu de la mémoire de masse peut être assimilé à une chaîne continue de mots de code disposés dans l'ordre chronologique (le chargement et la lecture de la mémoire étant séquentiels). La concaténation des mots de code sucessifs permet d'effectuer les transferts vers la mémoire de masse avec le maximum d'efficacité puisque ces transferts se font en parallèle et que les opérations séquentielles (transferts de 1 vers 2, puis de 2 vers 3, le cas échéant via les registres intermédiaires, et de 3 vers la mémoire de masse) peuvent être cadencées par une horloge commune (traitement "pipe-line").

TABLEAU N° 1

| q | f [T] | f [B] | transferts | fanions |
|---|---|---|---|---|
| 0 | x | x | aucun | |
| 1 | 0 | x | [T] = [N0] | f [T] = 1 |
| | 1 | 0 | [B] = [N0] [T] | f [B] = 1<br>f [T] = 0 |
| | 1 | 1 | [W] = [N0] [T] [B] | f [W] = 1<br>f [B] = 0<br>f [T] = 0 |
| 2 | 0 | 0 | [B] = [N1] [N0] | f [B] = 1 |
| | 0 | 1 | [W] = [N1] [N0] [B] | f [W] = 1<br>f [B] = 0 |
| | 1 | 0 | [B] = [N0] [T]<br>[T] = [N1] | f [B] = 1<br>f [T] = 1 |
| | 1 | 1 | [W] = [N0] [T] [B]<br>[T] = [N1] | f [W] = 1<br>f [B] = 0<br>f [T] = 1 |
| 3 | 0 | 0 | [B] = [N1] [N0]<br>[T] = [N2] | f [B] = 1<br>f [T] = 1 |
| | 0 | 1 | [W] = [N1] [N0] [B]<br>[T] = [N2] | f [W] = 1<br>f [T] = 1<br>f [B] = 0 |
| | 1 | 0 | [W] = [N2] [N1] [N0] [T] | f [W] = 1<br>f [T] = 0 |
| | 1 | 1 | [W] = [N0] [T] [B]<br>[B] = [N2] [N1] | f [W] = 1<br>f [B] = 1<br>f [T] = 0 |
| 4 | 0 | 0 | [W] = [N3] [N2] [N1] [N0] | f [W] = 1 |
| | 0 | 1 | [W] = [N1] [N0] [B]<br>[B] = [N3] [N2] | f [W] = 1<br>f [B] = 1 |
| | 1 | 0 | [W] = [N2] [N1] [N0] [T]<br>[T] = [N3] | f [W] = 1<br>f [T] = 1 |
| | 1 | 1 | [W] = [N0] [T] [B]<br>[B] = [N2] [N1]<br>[T] = [N3] | f [W] = 1<br>f [B] = 1<br>f [T] = 1 |

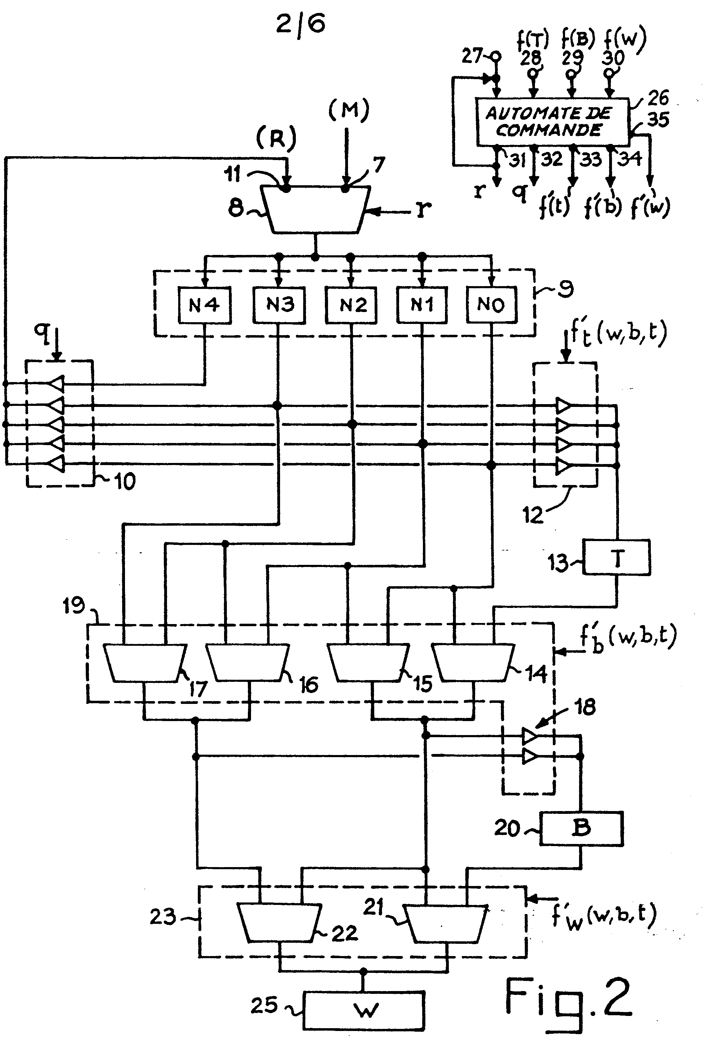

On a représenté sur la figure 2 le bloc-diagramme d'un dispositif formatteur fonctionnant de la façon décrite ci-dessus. La sortie du compresseur (non représenté sur la figure 2) est reliée à une entrée 7 d'un dispositif de cadrage 8, qui est, selon un mode de réalisation préféré, un multiplexeur. La sortie du dispositif 8 est reliée à l'entrée d'un registre 9 d'une capacité de vingt éléments binaires, et divisé en cinq tranches de quatre éléments binaires chacune, référencées N0 à N4 respectivement.

Les sorties des tranches N0 à N4 sont reliées à une entrée 11 du dispositif 8 via un multiplexeur 10 réalisé simplement à l'aide de cinq portes quadruples à trois états. Les sorties des tranches N0 à N3 sont, d'autre part, reliées via un multiplexeur 12 à l'entrée d'un regisre 13 à quatre cellules, le multiplexeur 12 étant réalisé de la même façon que le multiplexeur 10. La sortie du registre 13 est reliée à une entrée d'un multiplexeur élémentaire 14 dont l'autre entrée est reliée à la sortie de la tranche N0. La sortie de N0 est également reliée à une entrée d'un multiplexeur élémentaire 15 dont l'autre entrée est reliée à la sortie de N1, cette dernière étant également reliée à une entrée d'un multiplexeur élémentaire 16. La sortie de N2 est reliée d'une part à l'autre entrée du multiplexeur 16 et d'autre part à une entrée d'un multiplexeur élémentaire 17 dont l'autre entrée est reliée à la sortie de N3. Les sorties des multiplexeurs 14 à 17 sont reliées à un multiplexeur élémentaire 18. L'ensemble des multiplexeurs élémentaires 14 à 18 forme le multiplexeur 19. Les différents multiplexeurs élémentaires 14 à 17 peuvent être réalisés à l'aide de circuits intégrés de multiplexage classiques, et le multiplexeur 18 peut être réalisé à l'aide de portes à trois états.

La sortie du multiplexeur 18 est reliée à un registre 20 à huit cellules. La sortie du registre 20 est reliée à une entrée d'un multiplexeur élémentaire 21. Les sorties des registres 14 et 15 sont reliées d'une part à une autre entrée du multiplexeur 21, et d'autre part à une entrée d'un multiplexeur élémentaire 22 dont une autre entrée est reliée aux sorties des multiplexeurs 16 et 17. Les multiplexeurs élémentaires 21 et 22 forment le multiplexeur 23.

10

Les sorties des multiplexeurs 21 et 22 sont reliées à un registre 25, à seize cellules également. Les registres 13 , 20 et 25 correspondent respectivement aux registres T , B et W précités.

Le dispositif formatteur comporte également un automate de commande 26 commandant le dispositif de cadrage et les différents multiplexeurs décrits ci-dessus. L'automate 26 reçoit, sur une entrée 27 reliée au compresseur 1, la longueur des mots de code successifs, et reçoit sur trois autres entrées 28 à 30 les fanions $f(T)$, $f(B)$ et $f(W)$ indiquant l'état d'occupation des registres 13, 20 et 25 respectivement. L'automate 26 comporte cinq sorties différentes référencées 31 à 35. La sortie 31, produit l'information $\underline{r}$ de longueur du résidu, et commande le dispositif de cadrage 8 de la façon expliquée ci-dessous en référence au tableau 2. La sortie 32 produit l'information $q$ (égale à la partie entière de $1/n$, comme précisé ci-dessus) qui commande le multiplexeur 10 de façon expliquée ci-dessous. Les sorties 33 à 35 produisent des signaux $f'(t)$, $f'(b)$ et $f'(w)$ pour commander les multiplexeurs 12, 19 et 23 de la façon expliquée ci-dessus en référence au tableau 1, les aiguillages réalisés par ces multiplexeurs en fonction de ces signaux de commande étant évidents pour l'homme de l'art au vu du tableau 1.

Comme mentionné ci-dessus, les mots de code d'entrée provenant du compresseur doivent être introduits juste à gauche de l'éventuel résidu, qui est prélevé dans l'éventuelle tranche incomplète du registre 9, la position de cette tranche étant détectée grâce au critère $q$ : dans le multiplexeur 10, seule est validée par la commande $q$ la porte correspondant à la tranche dont le numéro est égal à $q$ : par exemple si $q = 2$, c'est-à-dire si le résidu est dans N2 et si on ne transfère que le contenu de N0 et N1 vers les registres situés en aval du registre 9, on valide la porte correspondant à N2. Ce résidu est cadré à droite dans le registre d'entrée du cadreur 8, et immédiatement à sa gauche on introduit les éléments binaires du mot de code incident M de la façon suivante :
- si on appelle $a0, a1, a2, ... am$ les éléments binaires de M, $g0, g1, g2$ les éléments binaires du résidu R, et $b0, b1, b2, ... bl$ les éléments

11

binaires du contenu C du registre d'entrée du cadreur (c'est-à-dire de (M)(R)), la table de vérité donnant la disposition des différents éléments binaires de R, M et C en fonction de $\underline{r}$ est donnée par le tableau 2 ci-dessous.

Tableau 2

| b1 ..................... b5 | b4 | b3 | b2 | b1 | b0 | r |
|---|---|---|---|---|---|---|
| .... | a4 | a3 | a2 | a1 | a0 | 0 |
| ... | a3 | a2 | a1 | a0 | g0 | 1 |
| ... | a2 | a1 | a0 | g1 | g0 | 2 |
| ... | a1 | a0 | g2 | g1 | g0 | 3 |

Etant données les explications ci-dessus, l'homme de l'art peut facilement réaliser l'automate de commande 26, à l'aide de mémoires mortes, par exemple, programmées de façon à obtenir les signaux r, q, f'(t), f'(b) et f'(w) à partir des valeurs d'entrée r, m, f(t), f(b), f(w).

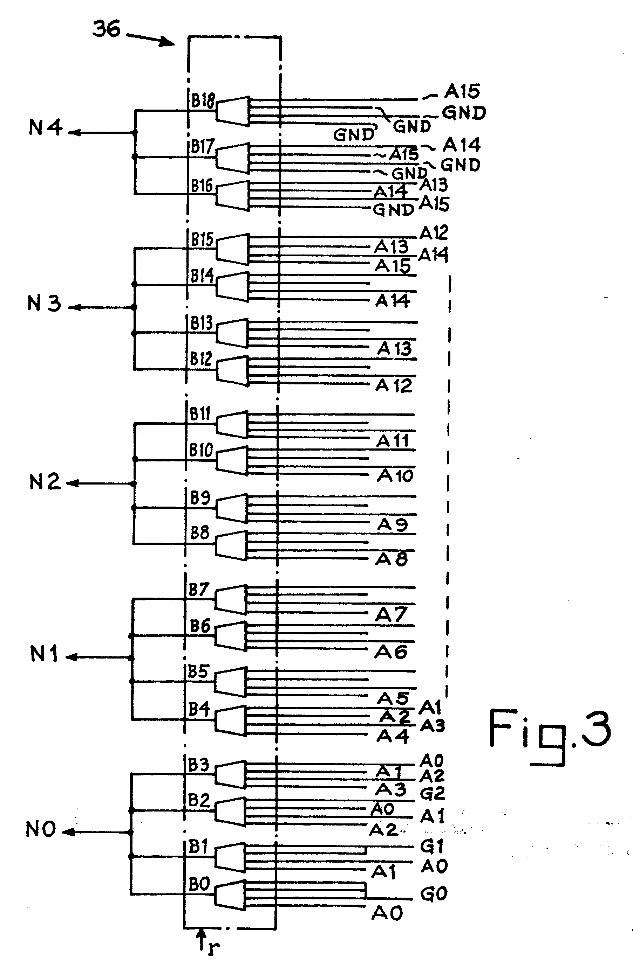

On a représenté sur la figure 3 le bloc-diagramme d'un mode de réalisation du cadreur de l'invention. Les éléments binaires A0 à A15 des mots de code M sont envoyés sur les entrées d'une rangée 36 de dix-neuf multiplexeurs élémentaires à quatre fils d'entrée et un fil de sortie chacun, selon les combinaisons suivantes, dans l'ordre : A0 - G0 (G0 sur 3 fils), A1 - A0 - G1 (G1 sur 2 fils), A2 - A1 - A0 - G2, A3 - A2 - A1 - A0, A4 - A3 - A2 - A1, A5 - A4 - A3 - A2, ..., masse (GND sur 3 fils) - A15. Sur les sorties des multiplexeurs élémentaires, on obtient respectivement B0, B1, ..., B18. Les éléments binaires B0 à B3 forment N0, et ainsi de suite jusqu'à N4, qui comprend B16 à B18.

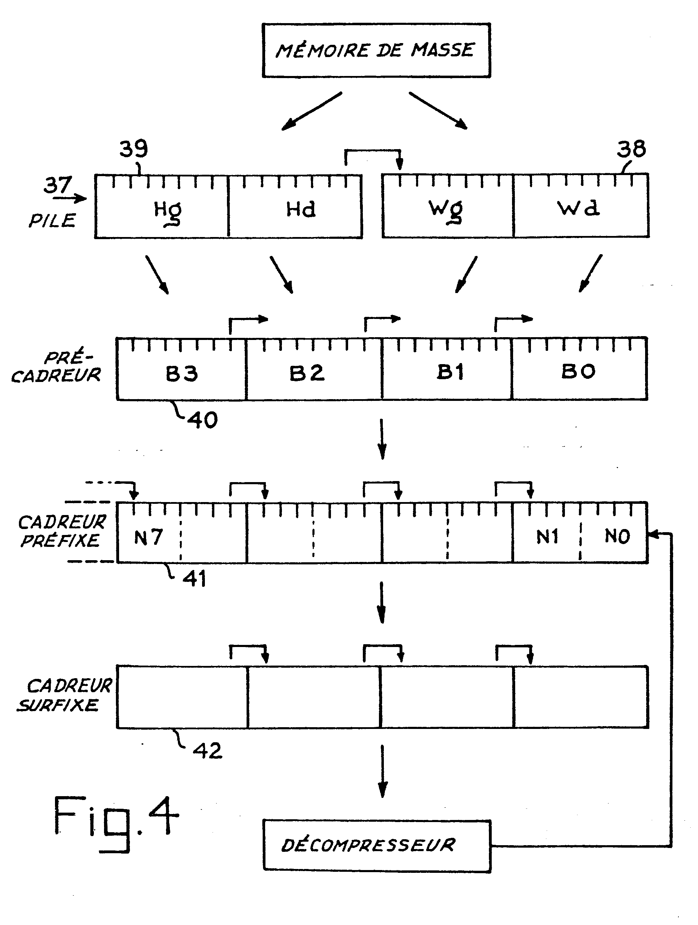

On va maintenant expliquer le fonctionnement du dispositif déformatteur en référence à la figure 4. La mémoire de masse envoie séquentiellement au dispositif déformatteur des mots de

12

longueur constante (16 éléments binaires dans le cas présent). Ce dispositif déformatteur est chargé de reconnaître les frontières de mots de code, d'extraire ces derniers et de les présenter, cadrés (par exemple à droite sur le dessin), au processeur de décompression. A l'initialisation, le premier mot de code est, bien entendu, cadré sur sa frontière (de droite), mais l'extraction des mots de code suivants produit un glissement de leur frontière antérieure (celle relative au mot précédent) vers la gauche d'une quantité égale à la longueur des mots venant d'être extraits. La fonction principale du déformatteur est de recadrer à droite chaque résidu subsistant éventuellement après extraction d'un mot de code reconnu, afin de présenter au décompresseur des mots de code, en particulier leurs préfixes, alignés sur une frontière. Cette opération de recadrage est réalisée en deux étapes, comme expliqué ci-dessous, afin de minimiser le nombre de transferts à y effectuer.

La première étape est dénommée "pré-cadrage". Les mots de longueur constante envoyés séquentiellement par la mémoire de masse sont rangés dans un registre 37 se composant d'un registre principal 38 et d'un registre auxiliaire 39. Si seul le contenu du registre 38 est envoyé au pré-cadreur 40, le contenu du registre 39 lui est ensuite transféré, et la mémoire de masse charge le registre 39. Si les contenus des deux registres 38 et 39 sont envoyés simultanément au pré-cadreur, la mémoire de masse charge le registre 38 puis le registre 39. Pour simplifier les explications, on considère le pré-cadreur 40 comme un registre ayant la capacité du registre 37, à savoir 32 éléments binaires pour le mode de réalisation préféré décrit ici.

On considère que dans le pré-cadreur 40 plusieurs mots sont répartis sur un certain nombre d'entités (B), chacune de capacité $b$ éléments binaires. Dans le cas présent $b = 8$ et le pré-cadreur comporte quatre entités référencées (B0) à (B3) de droite à gauche, d'une capacité d'un octet chacune. On suppose qu'après l'extraction d'un mot de code du pré-cadreur la frontière antérieure du code à traiter est décalée de g éléments binaires vers la gauche par rapport à l'extrémité de droite du pré-cadreur (tel que vu sur le dessin). Le pré-cadreur a pour fonction de décaler vers la droite son contenu d'un nombre entier s de fois b éléments binaires pour amener le premier élément binaire (définissant la frontière antérieure) du mot de code suivant à l'intérieur de l'entité B0. Si on appelle m1 la longueur du mot de code venant d'être extrait du pré-cadreur et d1 le décalage de sa frontière antérieure par rapport à l'extrémité de droite du pré-cadreur, on a : $g = m1 + d1$ (bien entendu, à l'initialisation m1 et d1 sont nulles). La frontière antérieure du mot de code à extraire doit donc être décalée vers la droite de : $s = $ Entier $(g/b)$. Après ce décalage, la frontière antérieure du mot à extraire sera distante de $d2 = g$ Modulo b par rapport à l'extrémité de droite du pré-cadreur, et bien entendu, la valeur de d2 est supérieure ou égale à zéro, mais inférieure à b.

Ainsi, connaissant la valeur de s, on effectue dans le pré-cadreur des transferts d'une entité (B) vers une autre située plus à droite avec un saut d'amplitude déterminé par s : si $s = 1$, les décalages ont lieu de proche en proche de gauche à droite, si $s = 2$, le contenu de B2 est transféré en B0, et ainsi de suite.

On procède ensuite au cadrage proprement dit, qui peut se décomposer en un cadrage du préfixe, puis en un cadrage du suffixe. Pour simplifier les explications, on assimile le cadreur du préfixe 41 à un registre, de même capacité que le pré-cadreur, et comportant donc comme ce dernier quatre entités (B). Si l'on considère que ces entités sont elles-mêmes constituées de modules de taille $n = b/2$, l'opération de cadrage consistera à amener sur une frontière de droite de module la frontière de mot de code actuellement déportée de d2 vers la gauche. L'amplitude d3 du décalage à réaliser est : $d3 = d2$ modulo n, d3 étant supérieure ou égale à zéro, mais inférieure à n. Le préfixe du mot de code à extraire sera cadré sur la frontière de droite de l'un des deux modules (No) ou (N1) de (B0) du cadreur 41 selon la valeur de $r = $ Entier $(d2/n)$ : si $r = o$, ce sera (No), et si $r = 1$, ce sera (N1).

14

Connaissant la valeur de r, et connaissant la longueur du mot de code (fournie par le décompresseur), il est facile d'extraire ce mot de code. L'exploitation du préfixe du mot de code peut fournir les informations nécessaires au cadrage éventuel du suffixe, réalisé par un cadreur du suffixe 42 identique au cadreur de préfixe et fonctionnant de la même façon que ce dernier.

Le fonctionnement du déformatteur est commandé par un automate de commande, similaire à celui du formatteur. Le registre 37 est appelé ci-dessous "pile", le registre 38 étant divisé en deux entités référencées (Wg) et (Wd) de gauche à droite, et le registre 39 étant divisé en deux entités référencées (Hg) et (Hd) de gauche à droite.

En fonction du nombre de sauts s que les octets provenant du registre 37 vont subir lors du pré-cadrage, il apparaît un vide sur la gauche du pré-cadreur, qui doit être comblé par un ou plusieurs octets prélevés dans le registre 37 qui subit donc également une "érosion", ce qui nécessite de le recharger à partir de la mémoire de masse. Le tableau 3 ci-dessous établit les changements d'états que subit l'automate de commande au cours de ces différents transferts. Les variables d'états utilisées pour cet automate sont : s et OP, qui est un indicateur de parité du nombre de sauts déjà effectués au niveau du pré-cadrage. Au niveau de la pile, on a trois opérations différentes : aucun chargement de la pile, un chargement simple (de 39 vers 38 et du disque vers 39), et un chargement double (du disque 39 et 38). Dans le tableau 3, la ligne de s = 4 correspond à l'initialisation de l'automate. Comme dans le cas du formatteur, l'automate du déformatteur peut être réalisé à l'aide de mémoires mortes, par exemple, dont la programmation est évidente pour l'homme de l'art à la lecture des explications ci-dessus et du tableau 3.

**T A B L E A U  N° 3**

| s | | OP | | transferts | | Opérations PILE |
|---|---|---|---|---|---|---|
| 0 | : | x | : | aucun | : | aucune |
| 1 | : | Pair | : | [B0] = [B1]<br>[B1] = [B2]<br>[B2] = [B3]<br>[B3] = [Wd]<br>OP = impair | : | aucune |
| | : | Impair | : | [B0]·= [B1]<br>[B1] = [B2]<br>[B2] = [B3]<br>[B3] = [Wg]<br>OP = pair | : | simple |
| 2 | : | Pair | : | [B0] = [B2]<br>[B1] = [B3]<br>[B2] = [Wd]<br>[B3] = [Wg]<br>OP = pair | : | simple |
| | : | Impair | : | [B0] = [B2]<br>[B1] = [B3]<br>[B2] = [Wg]<br>[B3] = [Hd]<br>OP = impair | : | simple |
| 3 | : | Pair | : | [B0] = [B3]<br>[B1] = [Wd]<br>[B2] = [Wg]<br>[B3] = [Hd]<br>OP = impair | : | simple |
| | : | Impair | : | [B0] = [B3]<br>[B1] = [Wg]<br>[B2] = [Hd]<br>[B3] = [Hg]<br>OP = pair | : | double |
| 4 | : | x | : | [B0] = [Wd]<br>[B1] = [Wg]<br>[B2] = [Hd]<br>[B3] = [Hg]<br>OP = pair | : | double |

16

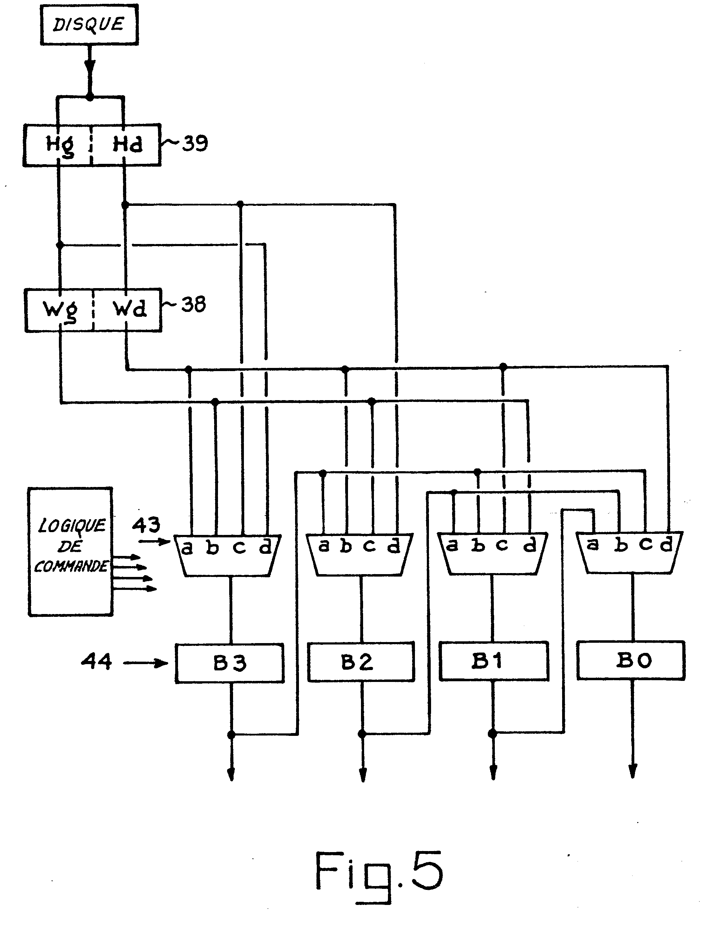

On a représenté sur la figure 5 le bloc-diagramme d'un pré-cadreur conforme à l'invention. Les registres 39 et 38 sont reliés en cascade à la sortie du lecteur de disques. La sortie de l'élément Wd du registre 38 est reliée à une entrée respectivement référencée, dans l'ordre, a,b,c,d, de chacun des quatre multiplexeurs élémentaires (à quatre entrées d'un octet chacun et une sortie sur un octet) d'un étage de multiplexage 43, les sorties de ces quatre multiplexeurs étant reliées chacune à un registre élémentaire d'un étage 44 de registres respectivement référencés B3 à B0 de gauche à droite. La sortie de l'élément Wg du registre 38 est reliée à une autre entrée (respectivement b,c,d) de chacun des trois multiplexeurs de gauche de l'étage 43. La sortie de l'élément Hd est reliée à une entrée (respectivement c,d) des deux multiplexeurs de gauche de l'étage 43, et la sortie de Hg est reliée à la quatrième entrée (d) du premier multiplexeur de gauche de l'étage 43. La sortie de B3 est reliée à une entrée (respectivement a,b,c,) de chacun des trois registres de droite de l'étage 43, la sortie de B2 est reliée à une entrée (respectivement a,b) de chacun des deux derniers registres de droite, et la sortie de B1 est reliée à une entrée (a) du dernier registre de droite de l'étage 43. Les sorties de B3 à B0 constituent les sorties du pré-cadreur.

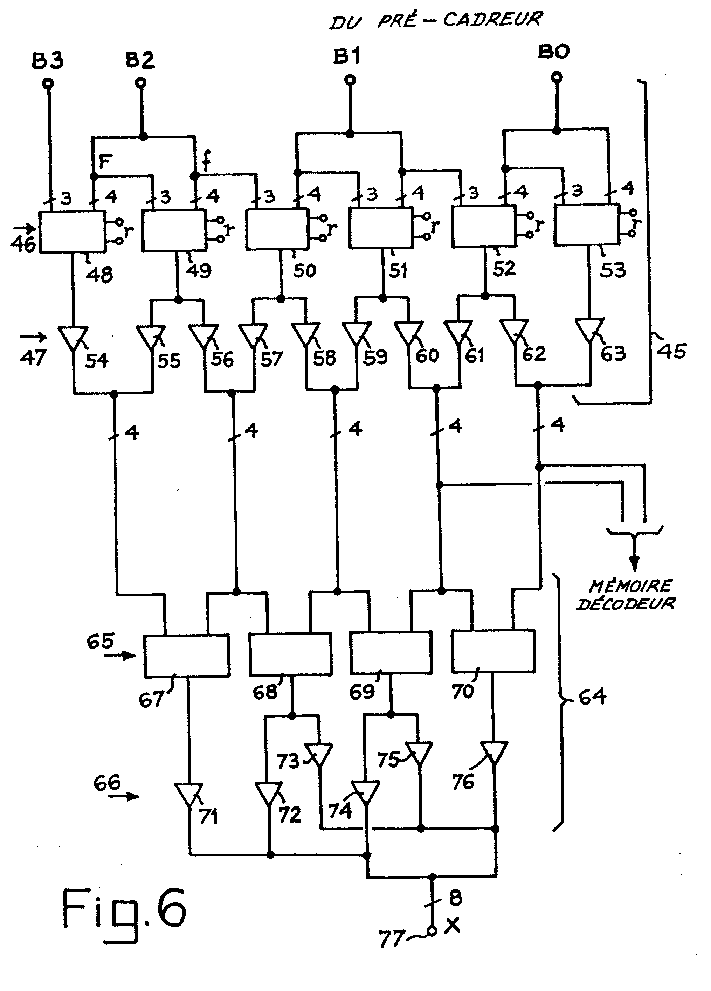

Le cadreur de préfixe 45 (figure 6) comporte un étage 46 de circuits logiques de décalage suivi d'un étage 47 de portes quadruples à trois états formant multiplexeur. L'étage 46 comporte six circuits élémentaires référencés 48 à 53 de gauche à droite sur le dessin, et pouvant réaliser le décalage de 0,1,2 ou 3 bits sur un mot d'entrée de 7 bits, en fonction de la valeur de $r$ (définie sur 2 bits). La sortie de B3 (sur 3 bits) et les 4 bits de poids faible de la sortie de B2 sont reliés au circuit 48. Toutes les sorties, sauf celle de poids le plus faible, de B2 sont reliées au circuit 49. Les trois sorties de poids les plus forts de B2 et les quatre sorties de poids les plus faibles de B1 sont reliées au circuit 50. Les sorties, sauf celle de poids le plus faible, de B1 sont reliées au circuit 51. Les trois sorties de poids les plus forts de B1 et les quatre sorties de poids les plus

faibles de B0 sont reliées au circuit 52, et enfin toutes les sorties, sauf celle de poids le plus faible, de B0 sont reliées au circuit 53.

L'étage 47 comporte dix portes quadruples à trois états, référencées 54 à 63 respectivement de gauche à droite sur le dessin. La porte 54 est reliée à la sortie de 48, les portes 55,56 à la sortie de 49, les portes 57,58 à la sortie de 50, les portes 59,60 à la sortie de 51, les portes 61,62 à la sortie de 52, et la porte 63 à la sortie de 53.

Les sorties des portes 60 et 61 d'une part, et des portes 62 , 63 d'autre part sont reliées à une mémoire de décodeur de décompresseur, par exemple telle que celle référencée 26 dans la Demande de Brevet français n° 85 17949 au nom de la demanderesse, cette mémoire fournissant la valeur décodée du pixel courant, et la longueur du code reconnu.

Le cadreur de suffixe 64, branché en aval du cadreur de préfixe 45 comporte un étage 65 de circuits logiques de décalage suivi d'un étage 66 de portes quadruples à trois états formant multiplexeur. L'étage 65 comporte quatre circuits logiques 67 à 70. Les sorties de chacun des couples de portes 54 et 55, 56 et 57, 58 et 59, 60 et 61, 62 et 63 sont à chaque fois reliées à un bus à quatre conducteurs. Le circuit 67 est relié aux bus de sortie des portes 54 à 57, le circuit 68 aux bus de sortie des portes 56 à 59, le circuit 69 aux bus de sortie des portes 58 à 61, et le circuit 70 aux bus de sortie des portes 60 à 63.

L'étage 66 comporte six portes quadruples à trois états respectivement référencés 71 à 76, dont les sorties sont reliées par un bus à huit conducteurs à la sortie 77 du cadreur.

Les sorties des portes 71 , 72 et 74 sont reliées aux quatre conducteurs de poids faibles de ce bus, et les sorties des portes 73 , 75 et 76 sont reliées aux conducteurs de poids forts de ce bus.

18

REVENDICATIONS

1. Procédé de formattage et de déformattage de données résultant du codage d'informations numériques à l'aide d'un code à longueur variable, selon lequel au formattage, on concatène des mots codés de longueur variable et on découpe en entités de même longueur la chaîne ainsi obtenue, et on envoie consécutivement ces entités à un dispositif de mémoire de masse, la longueur de ces entités étant égale au nombre d'éléments binaires pouvant être envoyés simultanément à ce dispositif de mémoire, et au déformattage on effectue les opérations inverses en vue de restituer lesdits mots codés, caractérisé par le fait qu'il consiste au formattage, à mémoriser provisoirement et consécutivement les mots codés dans un registre d'entrée, en les cadrant, à la suite d'un éventuel résidu vers l'une des extrémités de ce registre, à les diviser, à partir de ladite extrémité, en tranches adjacentes de même longueur, la tranche comprenant l'autre extrémité pouvant être incomplète, et constituant ledit résidu, ces tranches comportant quatre éléments binaires, puis à transférer du registre du niveau de départ vers un registre de niveau de sortie, de capacité égale à la longueur desdites entités, en passant, le cas échéant, par des registres de niveaux intermédiaires, toutes les tranches complètes du niveau de départ, en décalant, le cas échéant, vers ladite extrémité du registre de niveau de départ la tranche incomplète restante, les registres de niveaux intermédiaires ayant chacun une capacité égale à un multiple entier de la longueur d'une tranche, cette capacité allant en croissant du niveau de départ au niveau d'arrivée, les tranches complètes étant transférées après celles des niveaux intermédiaire, dans l'ordre, en priorité vers le niveau d'arrivée jusqu'à achèvement de son remplissage, les tranches qui ne peuvent, le cas échéant, être transférées vers ce niveau d'arrivée du fait de son plein remplissage, étant transférées vers les registres de niveaux intermédiaires de manière à remplir soit, en priorité, ceux

19

contenant déjà des tranches n'ayant pu précédemment être transférées vers le niveau d'arrivée, puis ceux dont la capacité est la plus proche de celle nécessaire pour loger les tranches restantes, en utilisant le minimum de niveaux, soit, si tous les niveaux intermédiaires sont vides, de manière à remplir un ou plusieurs de ces niveaux intermédiaires en en utilisant le minimum, le contenu de ces niveaux intermédiaires étant ensuite, en priorité, transféré vers le niveau d'arrivée, en respectant l'ordre d'ancienneté, le contenu du niveau d'arrivée étant transféré vers le dispositif de mémoire de masse dès qu'il est plein, et au déformattage à mémoriser provisoirement et consécutivement les tranches successives des codes concaténés en provenance de la mémoire de masse dans un registre de niveau supérieur de capacité au moins égale au plus long code utilisé, à pré-cadrer vers l'une des extrémités de ce registre le code le plus proche de cette extrémité du registre de façon que l'extrémité du code la plus proche de cette extrémité du registre arrive à l'extrémité d'une des zones d'extrémité de longueur déterminée du registre par décalage d'un nombre entier de fois la longueur de la zone, à transférer au moins partiellement dans un ou plusieurs registres intermédiaires le code ainsi pré-cadré en le cadrant sur une extrémité de ces registres, et à transférer dans un registre de sortie le code ainsi cadré.

2. Procédé selon la revendication 1, caractérisé par le fait que l'on cadre d'abord le préfixe du code, puis son suffixe.

3. Dispositif de formattage et de déformattage de données résultant du codage d'informations numériques à l'aide d'un code à longueur variable, caractérisé par le fait que son formatteur comporte un dispositif cadreur (8) relié à l'entrée d'un registre d'entrée (9) dont la sortie est reliée d'une part à une entrée (11) du dispositif cadreur via un premier multiplexeur (10), d'autre part un premier registre intermédiaire (13) via un second multiplexeur (12), et d'autre part à un troisième multiplexeur (19), la sortie du premier registre intermédiaire étant également reliée à ce troisième multiplexeur, la sortie du troisième multiplexeur étant reliée à un second

20

registre intermédiaire (20) et à un quatrième multiplexeur (23) auquel est également reliée à la sortie du second registre intermédiaire, la sortie du quatrième multiplexeur étant reliée à un registre de sortie (25).

4. Dispositif de formattage et de déformattage de données selon la revendication 3, caractérisé par le fait que son déformatteur comporte un pré-cadreur (40) suivi d'un cadreur (41 , 42), le pré-cadreur comportant au moins un registre d'entrée (38 , 39) suivi d'un multiplexeur (43) et d'un registre de pré-cadrage (44), le cadreur comportant au moins un étage de circuits logiques de décalage (46) et un multiplexeur (47).

5. Dispositif de formattage et de déformattage de données selon la revendication 4, caractérisé par le fait que le cadreur comporte un cadreur de préfixe (45) suivi d'un cadreur de suffixe (64) comprenant chacun un étage de circuits logiques de décalage (46 , 65) et un multiplexeur (47 , 66).

Fig.1

Fig.2

Fig.3

MÉMOIRE DE MASSE

37
PILE

| Hg | Hd | Wg | Wd |

39                          38

PRÉ-
CADREUR

| B3 | B2 | B1 | B0 |

40

CADREUR
PRÉFIXE

| N7 | | | N1 | N0 |

41

CADREUR
SURFIXE

42

DÉCOMPRESSEUR

Fig.4

Fig.5

Fig.6

0233096

# RAPPORT DE RECHERCHE EUROPEENNE

Office européen des brevets

Numero de la demande

EP 87 40 0038

## DOCUMENTS CONSIDERES COMME PERTINENTS

| Catégorie | Citation du document avec indication, en cas de besoin. des parties pertinentes | Revendication concernée | CLASSEMENT DE LA DEMANDE (Int. Cl.4) |
|---|---|---|---|
| A | EP-A-0 040 025 (AM INTERNATIONAL INC.) * Page 2, lignes 10-14; page 3, ligne 29 - page 4, ligne 25; page 13, ligne 14 - page 17, ligne 16; page 18, ligne 5 - page 19, ligne 5; page 24, ligne 14 - page 40, ligne 6; revendications 1-10,14-17 * | 1-5 | G 11 B 20/12 H 03 M 7/30 G 06 F 5/06 // G 06 F 3/06 G 11 B 20/10 |
| A | EP-A-0 098 153 (NIPPON TELEGRAPH AND TELEPHONE PUBLIC CORP.) * Page 5, line 2 - page 15, ligne 28 * | 1,3 | |
| A | DE-A-2 948 770 (XEROX CORP.) * Page 10, ligne 19 - page 13, ligne 1; page 14, lignes 5-31; page 16, ligne 10 - page 18, ligne 1; figures 1,4 * | 1,3 | **DOMAINES TECHNIQUES RECHERCHES (Int. Cl.4)** |
| A | IBM TECHNICAL DISCLOSURE BULLETIN, vol. 19, no. 5, octobre 1976, pages 1892-1895, New York, US; Y. DISHON et al.: "Variable-length data assembler" * En entier * | 1,3 | G 11 B H 03 M H 04 N G 06 F |

--- -/-

Le présent rapport de recherche a été établi pour toutes les revendications

| Lieu de la recherche | Date d'achèvement de la recherche | Examinateur |
|---|---|---|
| LA HAYE | 22-04-1987 | DAALMANS F.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

## DOCUMENTS CONSIDERES COMME PERTINENTS

Page 2

| Catégorie | Citation du document avec indication, en cas de besoin, des parties pertinentes | Revendication concernée | CLASSEMENT DE LA DEMANDE (Int Cl.4) |
|---|---|---|---|
| A | IBM TECHNICAL DISCLOSURE BULLETIN, vol. 20, no. 12, mai 1978, pages 5332-5333, New York, US; J.W. PEAKE: "Parallel decoding of variable length codewords" <br> * En entier * | 1,2,4, 5 | |
| A | IBM TECHNICAL DISCLOSURE BULLETIN, vol. 26, no. 9, février 1984, pages 4794-4797, New York, US; J.W. PEAKE: "Decompaction" <br> * En entier * | 1,2,4, 5 | |
| A | GB-A-2 012 462 (NCR CORP.) <br><br> * Page 2, ligne 98 - page 3, ligne 7 * | 1,2,4, 5 | |
| A | US-A-3 918 047 (DENES) <br> * En entier * | 1,2,5 | |
| A | DE-A-2 552 694 (WITEC WISSENSCHAFTLICH-TECHNISCHE BERATUNGS- UND ENTWICKLUNGSGESELLSCHAFT d.b.R.) <br> * En entier * | 1 | |
| A | EP-A-0 142 439 (THOMSON-CGR) <br> * En entier * | 1,3 | |

DOMAINES TECHNIQUES RECHERCHES (Int. Cl.4)

Le présent rapport de recherche a été établi pour toutes les revendications

| Lieu de la recherche | Date d'achèvement de la recherche | Examinateur |
|---|---|---|
| LA HAYE | 22-04-1987 | DAALMANS F.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82